# EUROPEAN PATENT SPECIFICATION

(11) **EP 2 948 779 B1**
(45) Date of publication and mention of the grant of the patent: **02.08.2017**
(21) Application number: 14703509.1
(22) Date of filing: 23.01.2014
(51) Int. Cl.: G01R 15/20

(54) **FLEXIBLE MAGNETIC FIELD SENSOR**
FLEXIBLER MAGNETFELDSENSOR
CAPTEUR DE CHAMP MAGNÉTIQUE SOUPLE

(30) Priority: 25.01.2013 US 201361756525 P
(43) Date of publication of application: 02.12.2015
(73) Proprietor: Poem Technology LLC, Huntington, NY 11743 (US)
(72) Inventor: STILLMAN, Arnold, Huntington, NY 11743 (US)
(74) Representative: Bugnion Genève
(86) International application number: PCT/US2014/012779
(87) International publication number: WO 2014/116848

(56) References cited:
- WO-A1-90/06519
- US-A- 5 180 970
- US-A1- 2006 012 459

## Description

### BACKGROUND

### 1. Field of the Invention

The present disclosure is related to flexible magnetic field sensors. In particular, disclosed is magnetic field sensor that can be formed around a current carrying element to detect the current flowing in the element.

### 2. Description of the Related Art

It is known to measure electric current in a conductor by measuring the generated magnetic field with a coil positioned around or in close proximity to the conductor being monitored. Such coils are known as Rogowski Coils. The magnetic field caused by the current flowing in the monitored conductor induces a voltage between the ends of the coil sensor conductor in proportion to the current flowing in the monitored conductors. The induced voltage, or output signal of the Rogowski Coil is read by a signal processing circuit for further processing, such as for example, a microprocessor or voltage divider circuit.

Flexible current sensors are based on flexible inductive coils that can be formed to create a closed path aground, the measured current carrying conductor. A flexible current sensor generally has a form of sensing cable equipped with a mechanical coupling system for either fixing or releasing the sensor cable ends to and from mutually a closed position. The sensing cable consists of sensing coil wound on cylindrical flexible core, optional electrical shielding located over the sensing coil and outer isolation coat. In order to convert the coil voltage to output signal proportional to current an electronic integrator circuit is usually part of the flexible current sensor.

Current meters such as ammeters and Hall-effect magnetic field sensors are rigid devices.

Ammeters are series-connected devices that measure current flowing through them; they requiring a break in the measured circuit. Hall effect devices are rigid assemblies that clamp onto the circuit element to measure the magnetic field produced by the current. They require shields to eliminate the effects of stray magnetic fields on the Hall effect sensor. The clamps used in Hall-effect devices are either of the hinged rigid pliers-type for temporary spot measurements or they are permanent devices attached with clamps or fasteners so as to surround the current-carrying element. Both types of devices require at least several minutes of skilled labor to install.

WO 90/06519 discloses a current sensing device particularly for rotor ground fault detection in a highly inductive field is able to sense and identify the location of low order fault current when the load current in conductors is on the order of at least 1,000 amperes. Laminated strips of magnetic material are flexible to be located ideally about the conductors to maximize the sensitivity signal and minimize the effect of electromagnetic radiation. The current sensor includes three sets of laminations, the central laminations being for magnetization sensing, the inner laminations being for magnetic filtering, and outer laminations being for magnetic shield. Magnetic separation exists between each lamination set. Electrical insulation is located about the inner and outer sets.

US 5 180 970 discloses a current sensor with a flux concentrator which is made of two or more annular laminae. The laminae, or lamina plate, each are provided with a gap formed in its circumferential length. Each lamina has a gap which is defined by two opposing faces. The laminae are stacked with their planar surfaces in contact and in such a way so as to define a central opening. The gaps of the laminae are arranged proximate each other. One lamina is rotated relative to another to change the width of the effective gap by misalign the faces of the one gap relative to another. The lamina is rotated during the manufacture of the current sensor while an output voltage signal is measured as a function of a current passing through an opening of the flux concentrator. The degree of rotation of the lamina is determined as a function of the output signal to achieve a preselected current/voltage relationship. By achieving a consistent relationship between current sensors made in accordance with the present invention, interchangeability from one current sensor to another can be achieved in a low costs current sensor.

US 2006/012459 discloses a current sensor (1) for measuring a magnetic field (8) induced by a current of charged particles (3) having at least one magneto resistive sensor element (2;6;12;16 ) for enclosing the magnetic field induced by the current of charged particles, the magneto resistive sensor element being arranged perpendicularly to the current (3) during use. A method for accurately determining a current of charged particles is also disclosed making use of the current sensor (1). Further a protective switch device (30) is disclosed for protecting a user of an electrical device (31) by switching a supply current to the electric device off in case of malfunction of the electric device is also provided comprising the above current sensor (1).

### SUMMARY OF THE DISCLOSURE

In one embodiment, a flexible magnetic sensor according to the present disclosure includes a flexible sensor element partially surrounded by a a flexible shield. The flexible sensor element is constructed of a plurality of laminae that are magnetically permeable, substantially flat, disposed one upon another and electrically insulated from one another. The plurality of laminae is fixed together on a first end and free to slide over one another when the flexible magnetic sensor is formed into a shape.

In one aspect, the laminae in the plurality of laminae have varying lengths and are vertically aligned at a first end. In a particular aspect, the lengths of the laminae are selected so that second ends of the plurality of laminae are substantially aligned with one another when the flexible magnetic sensor is formed into a cylinder having a gap in the periphery.

The flexible magnetic sensor can include a connector to connect the first end of each particular lamina to a corresponding second end of each particular lamina across the gap to complete a magnetic circuit of the particular laminae. In an aspect, the connector fixes together the plurality of laminae on the first end and the second end.

In another embodiment, a flexible magnetic sensor according to the present disclosure includes a first plurality of laminae disposed in a first stack, each lamina of the first plurality being magnetically permeable and electrically insulated from one another, a second plurality of laminae disposed in a second stack, each lamina of the second plurality being magnetically permeable and electrically insulated from one another, and a third plurality laminae disposed in a third stack, each lamina of the third plurality being magnetically permeable and electrically insulated from one another. The second stack and the third stack disposed on the first stack to form a U-shaped channel therewith A sensor element is disposed in the U-shaped channel. A first end of the first stack, a first end of the second stack, and a first end of the third stack are aligned vertically and fixed together, and a second end of the first stack, a second end of the second stack, and a second end of the third stack free to slide over one another when the flexible magnetic sensor is formed into a shape

In one aspect, the width of the laminae in the first stack is greater than the width of the laminae in the second stack and the third stack.

In another aspect, the flexible magnetic sensor includes a plurality of electrically insulating laminae one of which is disposed between successive laminae of the first stack, the second stack, and the third stack.

In another aspect, the laminae in the first stack, the second stack, and the third stack have varying lengths. In a particular implementation, the lengths of the laminae in each of the first stack, second stack, and third stack are selected so that second ends of the plurality of laminae are substantially aligned with one another when the flexible magnetic sensor is formed into a cylindrical shape having a gap in the perimeter.

In another aspect, the flexible magnetic sensor includes a connector to connect a first end of each particular lamina on the first stack, the second stack, and the third stack to a corresponding second end of each particular lamina across the gap to complete a magnetic circuit of the particular laminae. The plurality of magnetically permeable it the first stack, the second stack and the third stack are fixed together at the first end by the connector. The connector fixes the second ends of the laminae in the first stack, the second stack, and the third stack, together after forming the flexible magnetic sensor into the cylindrical shape.

In another aspect, laminae in the first stack, the second stack, and the third stack have varying lengths and a second end is beveled.

The present flexible magnetic sensor has the advantage of providing a sensor that forms a tape composite structure that can make assembly more economical to produce than conventional sensors. Also, mechanical simplicity make the present sensor more economical to produce than conventional magnetic sensors.

### BRIEF DESCRIPTION OF THE DRAWINGS

FIG. 1 is a functional diagram of a flexible magnetic field sensor according to the present disclosure.
FIG.2 illustrates a flexible field sensor of the present design used with a transducer.
FIG. 3 is an illustration of the assembly of a flexible current sensor according to the present.
disclosure having magnetic insulting laminae with an embedded current sensing device.
FIG. 4 illustrates a cross sectional view of a flexible current sensor.
FIG. 5 illustrates a perspective view of an embodiment of the disclosed flexible sensor before forming into a shape.

### DETAILED DESCRIPTION

Disclosed is a flexible composite structure resembling a thick tape that encircles a current-carrying clement It is easily attached and removed an indefinite number of times. Other such devices of this type are mechanically robust and somewhat complex, causing them to be expensive to manufacture. The present devices an inexpensive sensor for use as input devices in, for example, a smart-grid system.

The disclosed device can shield a toroidal or ring-shaped current sensor from stray magnetic fields while being mechanically flexible to the extent that the device can be wrapped around a current-carrying element. The disclosed device is a flexible tape comprised of layers of magnetically permeable material that acts a shield for an embedded field sensing element. The shield is effective to reduce interfering or stray magnetic field strengths that can adversely affect operation of the embedded field sensing element. It is noted that the current carrying element is not limited to metallic wires or even semiconductors. It is contemplated, that current in the form of beams can also be measure. That is, the flexible magnetic sensor may be formed around an electric flow that induces a voltage in a surrounding sensor through a magnetic field.

Unlike the Rogowski coil, the disclosed sensor is not dependent on voltage that is induced in a coil that is proportional to the rate of change - the derivative - of magnetic flux caused by the changing current in the conducting element Accordingly, the Rogowski coil can only be used in alternating current (AC) applications and the output of the Rogowski coil is usually connected to an integrator circuit to provide an output signal that is proportional to the current. The present flexible sensor may be used to measure current in both AC and direct current (DC) current carrying elements because the sensing element is not dependent on the rate of change of current in the current carrying element. The present flexible sensor also does not require the precision assembly techniques required of the voltage-sensing loops in a Rogowski coil, since it has none of these loops. Rogowski coils cannot take advantage of the shielding method in the present flexible sensor since doing so results in or the output voltage of the Rogowski coil.

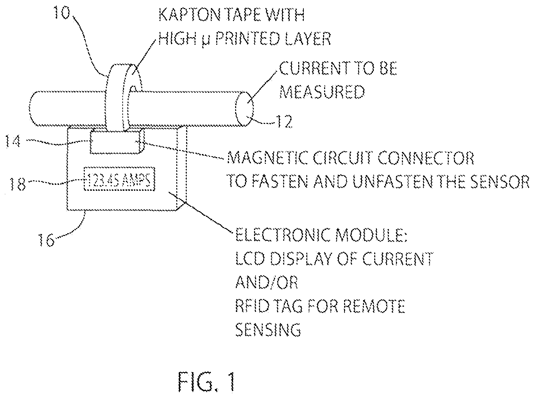

FIG. 1 illustrates a functional application of an embodiment of a flexible magnetic sensor according to the present disclosure acting as a flexible current sensor 10 to detect current flow in a current carrying element. Flexible current sensor 10 includes layers of magnetically permeable material providing a magnetic shield for an embedded magnetic sensing element. Sensor 10 is formed to substantially surround a current carrying element 12, such as an electrical wire. Ends of the flexible current sensor are separated from one another - as discussed in detail herein below to accommodate a transducer, not shown, in a gap between the ends. The transducer provides an output based upon current sensed by the flexible current sensor 10, which is then provided to an electronic processor 16. Electronic processor 16 can determine an amount of current flow in current carrying element 12, which can may be displayed on a display 18, transmitted to a remote location, sensed by a Radio Frequency Identification (RFID) tag, or any other such use. A magnetic circuit connector 14 connects a respective end of each layer of permeable magnetic material one to another across the gap.

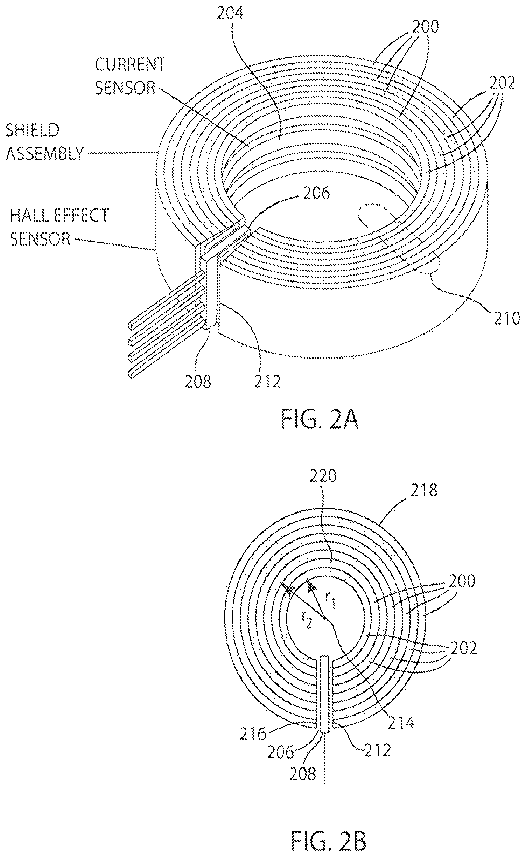

FIG. 2A illustrates a partial view of an embodiment of a flexible magnetic sensor formed into a ring or toroid shape. A sensing element 204 is used to sense a magnetic field resultant from current flowing in a current carrying element and respond with an output proportional to the magnitude and direction of the current flow. Sensing element 204 is magnetically insulated by a magnetic shield 210 from stray magnetic fields that may cause inaccuracies in the output provided by sensor element 204. Magnetic shield 210 is comprised of magnetically permeable laminae 200 laid one upon another and form a U-shaped channel into which the sensor element 204 is disposed. That is, magnetic shield 210 partially surrounds sensing element 204.

The material used for the magnetically permeable laminae is selected for high permeability and includes mu-metal and/or metallic spin glasses, although other materials are contemplated. Laminae 200 are composed of magnetic shielding material of magnetic permeability of at least 10,000 Gauss/Oersted and concentrate magnetic fields in their bulk. In doing so, the laminae prevent most of the field from passing through them. Several layers of such laminae can form a flexible tape that can be wound around a conductor carrying the current to be measured. Laminae 200 are thin to permit forming the flexible magnetic sensor about a current carrying element. The thicknesses of laminae 200 are in the range of 0.002 inches to 0.010 inch and 1 inch=2.54cm. This thickness range can avoid fragility of the shield 210 if the laminae are too thin and exceeding the elastic limit if too thick.

Laminae 200 are electrically insulated from one another by insulating layers 202. Insulating layers 202 can be layers of an insulating material such as Kapton® tape or an insulating coating on each lamina 200. Insulating layers 202 only need to be thick enough to provide electrical resistance between the magnetically permeable layers and is about 0.002 inch thick. In an implementation, an insulating layer 202 is bonded to a respective lamina.

Referring to FIG. 2B, a first end 212 of laminae 200 with the insulating layers 202 are fixed together. However, the remainder of the laminae 200 and insulating layers 202 are free to slide over one another to permit the forming of the flexible magnetic sensor into a shape. As shown, a gap 206 is provided during the forming between the first end and a second end 216 of the laminae to enable disposing of a transducer 208 in the gap. The transducer can be a giant magneto-resistance (GMR) sensor, Hall-Effect transducer, or any other element that can detect and provide an output in response to changes in sensor element 204. After forming, a second end 216 of the Laminae 200 and insulating layers 202 may be fixed together. A connector (not shown) can be used to connect the respective ends of each shielding lamina 200 to one another across gap 206 to complete the shielding circuit of the lamina. Electronic processor 16 can be attached to fixed end 212 of the flexible sensor and can include a clip, clamp, or other method of attaching the free end of the tape to the electronics assembly.

Laminae 200 form a tape whose length equals the circumference of the flexible magnetic sensor formed into a hollow cylindrical shape having a center 214 minus a gap for insertion of the current measuring electronics. One end of the tape contains a fastening to make fast first end 212 of the set of laminae. The other end of the tape is free to allow the laminate to slide as the tape is wound around the current carrying element to be measured.

Accordingly, laminae 200 are not necessarily all the same length. That is, when the laminae tape is made the individual laminae are laid flat one upon the other. When formed into a hollow cylindrical shape, for example, the outermost lamina 218 can be longer than the innermost lamina 220. The difference in length of the laminae is so the gap is formed of substantially parallel ends 212, 216. For example, when a flexible sensor is formed into a cylindrical shape, a first lamina forms most of a cylinder having radius r₁ and a second lamina forms most of a cylinder having radius r₂. As such, the difference in length of the first lamina and the second lamina is 2*π*(r₂ - r₁). Moreover, the ends 212, 216 of each lamina may be beveled so the ends form a straight line when the flexible sensor is formed into a circle having a gap 206 of a predetermined distance.

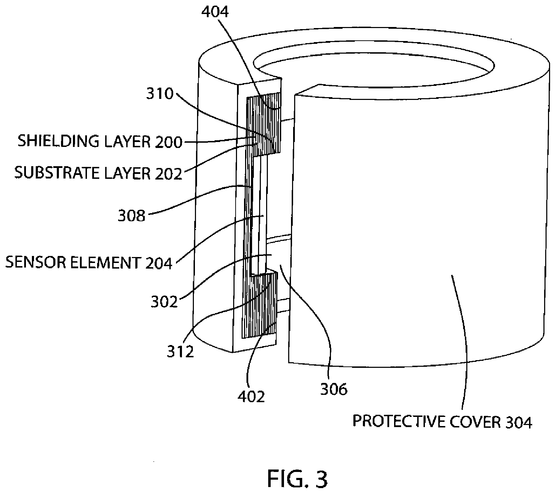

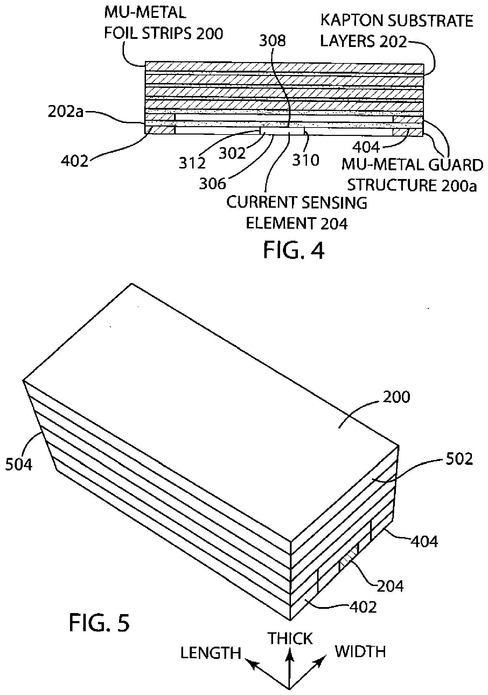

FIG. 3 and cross-section FIG. 4 illustrate the U-shaped channel 302 of a flexible magnetic sensor formed by laminae 200 and insulators 202. Sensor element 204 is disposed in U-shaped channel 302. The shielding laminae 200 are arrayed on each lamination so that when the entire plurality of laminae is wound around a current carrying element, a current sensing element is embedded within an area free of external interfering magnetic fields. The magnetic shield takes the form of an inverted letter "U," with the open end 306 of the configuration facing radially inward and the closed end 308 radially outward. The vertical sections 310, 312 of the U-shaped channel are made flexible by being composed of a plurality of laminations containing shielding material of a fraction of the width of the U-shape. Enough of the laminations stack upon each other to make a shielded volume approximately one-quarter as deep as the volume is wide. The horizontal section 402, 404 of the U-shaped shield has of a smaller set of laminae 200a and insulators 202a more narrow than laminae over the closed end of the U-shaped channel to accommodate the sensor element. In one implementation, the depth of the U-shape channel is no more than about one-quarter the maximum width of the channel. In a particular implementation, two or three laminae 200 are sufficient for shielding purposes. A jacketing material 304 can be provided over the assembly to prevent wear and tear on the shield and insulators.

As illustrated in FIG. 3, the flexible magnetic sensor is assembled by stacking a first plurality of laminae comprised of a magnetically permeable material one upon the other. The laminae are electrically insulated from one another. Stacking two additional pluralities of laminae substantially the same as the first plurality, but thinner in width, on the first plurality of laminae. Disposing the two additional pluralities of laminae on the first plurality of laminae to form a U-shaped channel. Disposing a sensor element in the resultant U-shaped channel forming a U-shaped sensor tape. Covering the U-shaped sensor tape with a flexible protective coating. Forming the resultant flexible sensor into a circular shape.

FIG. 5 illustrates an embodiment of the flexible sensor prior to forming into a shape, such as the hollow cylinder described above. As shown, the length of the laminae means the dimension that forms the perimeter of the cylindrical shape and the width is perpendicular thereto across the laminae. FIG. 5 also illustrates the embodiment of the flexible sensor where the laminae 200 are of differing lengths. Also shown is the vertical alignment in the thickness direction of the first end 502, which are fixed together, and the laminae beveled on the second end 504, which are not fixed together, prior to being formed into a shape.

The flexible magnetic sensor disclosed may be used in residential metering systems, smart grid systems for power monitoring, bench test instruments, and factory and plant floor equipment power monitoring. The flexible sensor can be formed around the conductor carrying the current to be measured. The free end of the tape connects to the electronics assembly with the aforementioned clamp or clip.

An ON/OFF switch may be incorporated or power for the electronics assembly may be initiated by remote methods. A battery may be used to power the electronic processor, which provides the amount of current measured as a visual display or as data transmitted electronically to a monitoring system. Transmission methods may include but are not limited to Bluetooth, Ethernet, wireless 802.11 data, RFID or optical links. Other uses for the flexible magnetic sensor are contemplated and include, but are not limited to, monitoring of beam intensity in accelerators, where the lack of an installed Rogowski coil limits the ability to measure beam intensity, DC measurements of photovoltaic solar cell outputs or batteries and battery packs, where the voltages are DC and not measurable by a Rogowski coil.

Other implementations are within the scope of the following claims.

## Claims

1. A flexible magnetic sensor, comprising:
a flexible sensor element (204);
a flexible shield partially surrounding the flexible sensor element and comprised of a plurality of laminae (200) that are magnetically permeable, substantially flat, disposed one upon another and electrically insulated from one another,
**characterised in that**
the plurality of laminae is fixed together on a first end and free to slide over one another when the flexible magnetic sensor is formed into a shape.

2. The flexible magnetic sensor according to claim 1, wherein the laminae in the plurality of laminae have varying lengths and vertically aligned at a first end.

3. The flexible magnetic sensor according to claim 2, wherein the lengths of the laminae are selected so that second ends of the plurality of laminae are substantially aligned with one another when the flexible magnetic sensor is formed into a cylinder having a gap in the periphery.

4. The flexible magnetic sensor according to claim 3, comprising:
a connector to connect the first end of each particular lamina to a corresponding second end of each particular lamina across the gap to complete a magnetic circuit of the particular laminae,
wherein the connector fixes together the plurality of laminae on the first end and the second end.

5. A flexible magnetic sensor, comprising:
a first plurality of laminae (200, 402, 404) disposed in a first stack, each lamina of the first plurality being magnetically permeable and electrically insulated from one another;
a second plurality of laminae (200) disposed in a second stack, each lamina of the second plurality being magnetically permeable and electrically insulated from one another;
a third plurality of laminae (200) disposed in a third stack, each lamina of the third plurality being magnetically permeable and electrically insulated from one another, the second stack and the third stack disposed on the first stack to form a U-shaped channel therewith, wherein the second and third stacks form opposing sides of the U-shaped channel and the first stack forms the bottom of the U-shaped channel;
a flexible sensor element (204) disposed in the U-shaped channel,
wherein a first end of the first stack, a first end of the second stack, and a first end of the third stack are aligned vertically and fixed together, and
**characterised in that**
a second end of the first stack, a second end of the second stack, and a second end of the third stack are free to slide over one another when the flexible magnetic sensor is formed into a shape.

6. The flexible magnetic sensor of claim 5, wherein the width of the laminae in the first stack is greater than the width of the laminae in the second stack and the third stack.

7. The flexible magnetic sensor of claim 6, comprising:
a plurality of electrically insulating laminae one of which is disposed between successive laminae of the first stack, the second stack, and the third stack.

8. The flexible magnetic sensor according to claim 5, wherein laminae in the first stack, the second stack, and the third stack have varying lengths.

9. The flexible magnetic sensor according to claim 8, wherein the lengths of the laminae in each of the first stack, second stack, and third stack are selected so that second ends of the plurality of laminae are substantially aligned with one another when the flexible magnetic sensor is formed into a cylindrical shape having a gap in the perimeter.

10. The flexible magnetic sensor according to claim 9, comprising:
a connector to connect a first end of each particular lamina on the first stack, the second stack, and the third stack to a corresponding second end of each particular lamina across the gap to complete a magnetic circuit of the particular laminae,
wherein the plurality of magnetically permeable laminae in the first stack, the second stack and the third stack are fixed together at the first end by the connector, and
wherein the connector fixes the second ends of the laminae in the first stack, the second stack, and the third stack, together after forming the flexible magnetic sensor into the cylindrical shape.

11. The flexible magnetic sensor according to claim 7, wherein a thickness of the laminae in the first stack, the second stack, and the third stack is in the range of 0.002 to 0.010 i inch and 1 inch=2.54cm.

12. The flexible magnetic sensor according to claim 11, wherein a thickness of each electrically insulating lamina is about 0.002 inch and 1 inch=2.54cm.

13. The flexible magnetic sensor according to claim 6, wherein laminae in the first stack, the second stack, and the third stack have varying lengths and a second end is beveled.

14. A method of forming a flexible magnetic sensor, comprising:
partially surrounding a flexible sensor element (204) with a a flexible shield to reduce the influence of stray magnetic fields on the flexible sensor, the flexible shield comprised of a plurality of (200) laminae that are magnetically permeable, substantially flat, disposed one upon another and electrically insulated from one another,
**characterised in that**
the plurality of laminae are fixed together on a first end and free to slide over one another when the flexible magnetic sensor is formed into a shape.

15. A method of forming a flexible magnetic sensor, comprising:
stacking a first plurality of laminae (200, 402, 404) one upon the other, wherein the laminae are formed from a magnetically permeable material and electrically insulated from one another;
stacking two additional pluralities of laminae (200) substantially the same as the first plurality, but thinner in width, on the first plurality of laminae;
disposing the two additional pluralities of laminae on the first plurality of laminae to form a U-shaped channel, wherein the two additional pluralities of laminae form opposing sides of the U-shaped channel and the first plurality of laminae forms the bottom of the U-shaped channel;
disposing a flexible sensor element (204) in the U-shaped channel to form a flexible sensor tape; and covering the flexible sensor tape with a flexible protective coating, **characterised in that** the plurality of laminae is fixed together on a first end and free to slide over one another when the flexible magnetic sensor is formed into a shape.

16. The method of claim 13, comprising forming the flexible covering and flexible sensor tape into a cylindrical shape.

## Patentansprüche

1. Flexibler magnetischer Sensor, der umfasst:
ein flexibles Sensorelement (204);
einen flexiblen Schild, der das flexible Sensorelement teilweise umgibt und aus einer Mehrzahl von dünnen Schichten (200) besteht, die magnetisch durchlässig, im Wesentlichen flach, übereinander angeordnet und in Bezug aufeinander elektrisch isoliert sind,
**dadurch gekennzeichnet, dass**
die Mehrzahl von dünnen Schichten an einem ersten Ende aneinander fixiert ist und übereinander frei gleitfähig ist, wenn der flexible magnetische Sensor in eine Form geformt ist.

2. Flexibler magnetischer Sensor nach Anspruch 1, wobei die dünnen Schichten in der Mehrzahl von dünnen Schichten variierende Längen aufweisen und an einem ersten Ende vertikal fluchten.

3. Flexibler magnetischer Sensor nach Anspruch 2, wobei die Längen der dünnen Schichten so ausgewählt sind, dass zweite Enden der Mehrzahl von dünnen Schichten miteinander im Wesentlichen fluchten, wenn der flexible magnetische Sensor in einen Zylinder mit einer Lücke in der Peripherie geformt ist.

4. Flexibler magnetischer Sensor nach Anspruch 3, der umfasst:
ein Verbindungselement, um das erste Ende jeder bestimmten dünnen Schicht mit einem entsprechenden zweiten Ende jeder bestimmten dünnen Schicht über die Lücke zu verbinden, um einen Magnetkreis der bestimmten dünnen Schichten zu schließen,
wobei das Verbindungselement die Mehrzahl von dünnen Schichten auf dem ersten Ende und dem zweiten Ende aneinander fixiert.

5. Flexibler magnetischer Sensor, der umfasst:
eine erste Mehrzahl von dünnen Schichten (200, 402, 404), die in einem ersten Stapel angeordnet sind, wobei jede dünne Schicht der ersten Mehrzahl magnetisch durchlässig und in Bezug aufeinander elektrisch isoliert ist;
eine zweite Mehrzahl von dünnen Schichten (200), die in einem zweiten Stapel angeordnet sind, wobei jede dünne Schicht der zweiten Mehrzahl magnetisch durchlässig und in Bezug aufeinander elektrisch isoliert ist,
eine dritte Mehrzahl von dünnen Schichten (200), die in einem dritten Stapel angeordnet sind, wobei jede dünne Schicht der dritten Mehrzahl magnetisch durchlässig und in Bezug aufeinander elektrisch isoliert ist, der zweite Stapel und der dritte Stapel auf dem ersten Stapel angeordnet sind, um damit einen U-förmigen Kanal zu bilden, wobei der zweite und der dritte Stapel gegenüberliegende Seiten des U-förmigen Kanals bilden und der erste Stapel den Boden des U-förmigen Kanals bildet;
ein flexibles Sensorelement (204), das im U-förmigen Kanal angeordnet ist,
wobei ein erstes Ende des ersten Stapels, ein erstes Ende des zweiten Stapels und ein erstes Ende des dritten Stapels vertikal fluchten und aneinander fixiert sind, und
**dadurch gekennzeichnet, dass**
ein zweites Ende des ersten Stapels, ein zweites Ende des zweiten Stapels und ein zweites Ende des dritten Stapels übereinander frei gleitfähig sind, wenn der flexible magnetische Sensor in eine Form geformt ist.

6. Flexibler magnetischer Sensor nach Anspruch 5, wobei die Breite der dünnen Schichten im ersten Stapel größer als die Breite der dünnen Schichten im zweiten Stapel und im dritten Stapel ist.

7. Flexibler magnetischer Sensor nach Anspruch 6, der umfasst:
eine Mehrzahl von elektrisch isolierenden dünnen Schichten, wobei eine davon zwischen sukzessiven dünnen Schichten des ersten Stapels, des zweiten Stapels und des dritten Stapels angeordnet ist.

8. Flexibler magnetischer Sensor nach Anspruch 5, wobei dünne Schichten im ersten Stapel, im zweiten Stapel und im dritten Stapel variierende Längen aufweisen.

9. Flexibler magnetischer Sensor nach Anspruch 8, wobei die Längen der dünnen Schichten in jedem des ersten Stapels, des zweiten Stapels und des dritten Stapels so ausgewählt sind, dass zweite Enden der Mehrzahl von dünnen Schichten miteinander im Wesentlichen fluchten, wenn der flexible magnetische Sensor in eine zylindrische Form mit einer Lücke im Perimeter geformt ist.

10. Flexibler magnetischer Sensor nach Anspruch 9, der umfasst:
ein Verbindungselement, um ein erstes Ende jeder bestimmten dünnen Schicht auf dem ersten Stapel, dem zweiten Stapel und dem dritten Stapel mit einem entsprechenden zweiten Ende jeder bestimmten dünnen Schicht über die Lücke zu verbinden, um einen Magnetkreis der bestimmten dünnen Schichten zu schließen,
wobei die Mehrzahl von magnetisch durchlässigen dünnen Schichten im ersten Stapel, im zweiten Stapel und im dritten Stapel durch das Verbindungselement am ersten Ende aneinander fixiert ist, und
wobei das Verbindungselement die zweiten Enden der dünnen Schichten im ersten Stapel, im zweiten Stapel und im dritten Stapel aneinander fixiert, nachdem der flexible magnetische Sensor in die zylindrische Form geformt wurde.

11. Flexibler magnetischer Sensor nach Anspruch 7, wobei eine Dicke der dünnen Schichten im ersten Stapel, im zweiten Stapel und im dritten Stapel im Bereich von 0,002 bis 0,010 Zoll liegt und 1 Zoll 2,54 cm ist.

12. Flexibler magnetischer Sensor nach Anspruch 11, wobei eine Dicke jeder elektrisch isolierenden dünnen Schicht ungefähr 0,002 Zoll beträgt und 1 Zoll 2,54 cm ist.

13. Flexibler magnetischer Sensor nach Anspruch 6, wobei dünne Schichten im ersten Stapel, im zweiten Stapel und im dritten Stapel variierende Längen aufweisen und ein zweites Ende abgeschrägt ist.

14. Verfahren zum Bilden eines flexiblen magnetischen Sensors, das umfasst:
teilweises Umgeben eines flexiblen Sensorelements (204) mit einem flexiblen Schild, um den Einfluss von Streumagnetfeldern auf den flexiblen Sensor zu verringern, wobei der flexible Schild aus einer Mehrzahl von dünnen Schichten (200) besteht, die magnetisch durchlässig, im Wesentlichen flach, übereinander angeordnet und in Bezug aufeinander elektrisch isoliert sind,
**dadurch gekennzeichnet, dass**
die Mehrzahl von dünnen Schichten an einem ersten Ende aneinander fixiert ist und übereinander frei gleitfähig ist, wenn der flexible magnetische Sensor in eine Form geformt ist.

15. Verfahren zum Bilden eines flexiblen magnetischen Sensors, das umfasst:
Stapeln einer ersten Mehrzahl von dünnen Schichten (200, 402, 404) übereinander, wobei die dünnen Schichten aus einem magnetisch durchlässigen Material gebildet und in Bezug aufeinander elektrisch isoliert sind;
Stapeln von zwei zusätzlichen Mehrzahlen von dünnen Schichten (200) im Wesentlichen wie die erste Mehrzahl, jedoch in einer dünneren Breite, auf der ersten Mehrzahl von dünnen Schichten;
Anordnen der zwei zusätzlichen Mehrzahlen von dünnen Schichten auf der ersten Mehrzahl von dünnen Schichten, um einen U-förmigen Kanal zu bilden, wobei die zwei zusätzlichen Mehrzahlen von dünnen Schichten gegenüberliegende Seiten des U-förmigen Kanals bilden und die erste Mehrzahl von dünnen Schichten den Boden des U-förmigen Kanals bildet;
Anordnen eines flexiblen Sensorelements (204) im U-förmigen Kanal, um ein flexibles Sensorband zu bilden; und
Bedecken des flexiblen Sensorbands mit einer flexiblen Schutzbeschichtung, **dadurch gekennzeichnet, dass** die Mehrzahl von dünnen Schichten an einem ersten Ende aneinander fixiert ist und übereinander frei gleitfähig ist, wenn der flexible magnetische Sensor in eine Form geformt ist.

16. Verfahren nach Anspruch 13, das das Formen der flexiblen Abdeckung und des flexiblen Sensorbands in eine zylindrische Form umfasst.

## Revendications

1. Capteur magnétique souple, comprenant :
un élément de capteur souple (204) ;
un blindage souple entourant partiellement l'élément de capteur souple et composé d'une pluralité de feuilles (200) qui sont magnétiquement perméables, sensiblement plates, disposées les unes sur les autres et isolées électriquement les unes des autres,
**caractérisé en ce que**
la pluralité de feuilles sont fixées les unes aux autres sur une première extrémité et libres de glisser les unes sur les autres lorsque le capteur magnétique souple est mis en forme.

2. Capteur magnétique souple selon la revendication 1, dans lequel les feuilles de la pluralité de feuilles ont des longueurs variables et sont alignées verticalement à une première extrémité.

3. Capteur magnétique souple selon la revendication 2, dans lequel les longueurs des feuilles sont sélectionnées de sorte que les deuxièmes extrémités de la pluralité de feuilles soient sensiblement alignées les unes avec les autres lorsque le capteur magnétique souple est mis sous la forme d'un cylindre comportant un entrefer dans la périphérie.

4. Capteur magnétique souple selon la revendication 3, comprenant :
un raccord pour relier la première extrémité de chaque feuille particulière à une deuxième extrémité correspondante de chaque feuille particulière de part et d'autre de l'entrefer afin de compléter un circuit magnétique des feuilles particulières,
dans lequel le raccord fixe les unes aux autres la pluralité de feuilles sur la première extrémité et la deuxième extrémité.

5. Capteur magnétique souple, comprenant :
une première pluralité de feuilles (200, 402, 404) disposées en une première pile, chaque feuille de la première pluralité étant perméable magnétiquement et isolée électriquement des autres ;
une deuxième pluralité de feuilles (200) disposées en une deuxième pile, chaque feuille de la deuxième pluralité étant perméable magnétiquement et isolée électriquement des autres ;
une troisième pluralité de feuilles (200) disposées en une troisième pile, chaque feuille de la troisième pluralité étant perméable magnétiquement et isolée électriquement des autres, la deuxième pile et la troisième pile étant disposées sur la première pile pour former un canal en forme de U avec celle-ci, dans lequel les deuxième et troisième piles forment les côtés opposés du canal en forme de U et la première pile forme le fond du canal en forme de U ;
un élément de capteur souple (204) disposé dans le canal en forme de U,
dans lequel une première extrémité de la première pile, une première extrémité de la deuxième pile et une première extrémité de la troisième pile sont alignées verticalement et fixées les unes aux autres, et
**caractérisé en ce que**
une deuxième extrémité de la première pile, une deuxième extrémité de la deuxième pile et une deuxième extrémité de la troisième pile sont libres de glisser les unes sur les autres lorsque le capteur magnétique souple est mis en forme.

6. Capteur magnétique souple selon la revendication 5, dans lequel la largeur des feuilles dans la première pile est plus grande que la largeur des feuilles dans la deuxième pile et la troisième pile.

7. Capteur magnétique souple selon la revendication 6, comprenant :
une pluralité de feuilles électriquement isolantes dont l'une est disposée entre les feuilles successives de la première pile, de la deuxième pile et de la troisième pile.

8. Capteur magnétique souple selon la revendication 5, dans lequel les feuilles dans la première pile, la deuxième pile et la troisième pile ont des longueurs variables.

9. Capteur magnétique souple selon la revendication 8, dans lequel les longueurs des feuilles dans chacune de la première pile, de la deuxième pile et de la troisième pile sont sélectionnées de sorte que les deuxièmes extrémités de la pluralité de feuilles soient sensiblement alignées les unes avec les autres lorsque le capteur magnétique souple est mis sous la forme d'un cylindre comportant un entrefer dans le périmètre.

10. Capteur magnétique souple selon la revendication 9, comprenant :
un raccord pour relier une première extrémité de chaque feuille particulière sur la première pile, la deuxième pile et la troisième pile à une deuxième extrémité correspondante de chaque feuille particulière de part et d'autre de l'entrefer afin de compléter un circuit magnétique des feuilles particulières,
dans lequel la pluralité de feuilles magnétiquement perméables dans la première pile, la deuxième pile et la troisième pile sont fixées les unes aux autres à la première extrémité par le raccord, et
dans lequel le raccord fixe les deuxièmes extrémités des feuilles dans la première pile, la deuxième pile et la troisième pile les unes aux autres après avoir mis le capteur magnétique souple en la forme cylindrique.

11. Capteur magnétique souple selon la revendication 7, dans lequel une épaisseur des feuilles dans la première pile, la deuxième pile et la troisième pile est dans la plage de 0,002 à 0,010 pouce et 1 pouce = 2,54 cm.

12. Capteur magnétique souple selon la revendication 11, dans lequel une épaisseur de chaque feuille électriquement isolante est d'environ 0,002 pouce et 1 pouce = 2,54 cm.

13. Capteur magnétique souple selon la revendication 6, dans lequel les feuilles dans la première pile, la deuxième pile et la troisième pile ont des longueurs variables et une deuxième extrémité est biseautée.

14. Procédé de formation d'un capteur magnétique souple, comprenant :
l'encerclement partiel d'un élément de capteur souple (204) avec un blindage souple afin de réduire l'influence des champs magnétiques parasites sur le capteur souple, le blindage souple étant composé d'une pluralité de feuilles (200) qui sont magnétiquement perméables, sensiblement plates, disposées les unes sur les autres et isolées électriquement les unes des autres,
**caractérisé en ce que**
la pluralité de feuilles sont fixées les unes aux autres sur une première extrémité et libres de glisser les unes sur les autres lorsque le capteur magnétique souple est mis en forme.

15. Procédé de formation d'un capteur magnétique souple, comprenant :
l'empilage d'une première pluralité de feuilles (200, 402, 404) les unes sur les autres, dans lequel les feuilles sont formées à partir d'un matériau magnétiquement perméable et sont isolées électriquement les unes des autres ;
l'empilage de deux pluralités supplémentaires de feuilles (200) sensiblement identiques à la première pluralité, mais plus petites en largeur, sur la première pluralité de feuilles ;
l'agencement des deux pluralités supplémentaires de feuilles sur la première pluralité de feuilles pour former un canal en U, dans lequel les deux pluralités supplémentaires de feuilles forment les côtés opposés du canal en U et la première pluralité de feuilles forme le fond du canal en U ;
l'agencement d'un élément de capteur souple (204) dans le canal en U pour former une bande de capteur souple ; et
le recouvrement de la bande de capteur souple avec un revêtement de protection souple, **caractérisé en ce que** la pluralité de feuilles sont fixées les unes aux autres sur une première extrémité et libres de glisser les unes sur les autres lorsque le capteur magnétique souple est mis en forme.

16. Procédé selon la revendication 13, comprenant la mise du recouvrement souple et de la bande de capteur souple en une forme cylindrique.
